**Europäisches Patentamt**

**European Patent Office**

**Office européen des brevets**

(19)

(11) Veröffentlichungsnummer: **0 231 902 B1**

(12) # EUROPÄISCHE PATENTSCHRIFT

(45) Veröffentlichungstag der Patentschrift:
**09.01.91 Patentblatt 91/02**

(51) Int. Cl.⁵: **G03F 7/18,** G03F 5/20,
G03F 7/24, G03F 7/20

(21) Anmeldenummer: **87101295.1**

(22) Anmeldetag: **30.01.87**

(54) **Verfahren zum Beschichten von Druckzylindern durch Aufbringen einer photovernetzbaren Aufzeichnungsschicht.**

(30) Priorität: **01.02.86 DE 3603087**

(43) Veröffentlichungstag der Anmeldung:
**12.08.87 Patentblatt 87/33**

(45) Bekanntmachung des Hinweises auf die
Patenterteilung:
**09.01.91 Patentblatt 91/02**

(84) Benannte Vertragsstaaten:
**AT BE CH DE ES FR GB IT LI NL SE**

(56) Entgegenhaltungen:
**DE-A- 1 772 662
FR-A- 803 918
FR-A- 2 286 420
FR-A- 2 391 072
US-A- 3 663 222**

(73) Patentinhaber: **BASF Aktiengesellschaft
Carl-Bosch-Strasse 38
D-6700 Ludwigshafen (DE)**

(72) Erfinder: **Bach, Helmut, Dr.
Dahlienstrasse 7
D-6704 Mutterstadt (DE)**
Erfinder: **Koch, Horst, Dr.
Wagnerstrasse 4
D-6520 Worms 24 (DE)**
Erfinder: **Ullemeyer, Peter
Vergissmeinichtweg 17
D-6720 Speyer (DE)**
Erfinder: **Dick, Gerd
Kranichstrasse 9
D-6700 Ludwigshafen (DE)**
Erfinder: **van Heuvelen, Jan Hendrik
Hogeweg 123
NL-7502 CC Losser (NL)**

## Beschreibung

Die Erfindung betrifft ein Verfahren zum Beschichten von Druckzylindern bzw. Druckzylindernhülsen durch Aufbringen einer vorgefertigten, festen, rückseitig vorbelichteten photovernetzbaren Aufzeichnungsschicht unter gleichzeitiger oder nachträglicher Einwirkung von Wärme und/oder Druck, ferner so hergestellte für den Rotationsdruck geeignete Druckformen.

Verfahren zum Beschichten und insbesondere endlosen Beschichten von gegebenenfalls vorbeschichten Druckzylindern oder Druckzylinderhülsen ("sleeves") mit einer photovernetzbaren Aufzeichnungsschicht durch Aufbringen einer vorgefertigten festen Aufzeichnungsschicht auf den gegebenenfalls vorbeschichteten Druckzylinder oder die Druckzylinderhülse zur Herstellung von Druckformen für den Rotationsdruck sind an sich bekannt. Zum Stand der Technik sei z.B. verwiesen auf die EP-A 40 893, 43 623, 111 371 sowie die DE-B 27 22 896, DE-A 28 42 440, 28 44 426, 29 11 908 und 31 25 564. Es ist auch bekannt, photovernetzbare Aufzeichnungsschichten auf die Zylinder- oder Zylinderhülsen aufzubringen und die Stoßkanten der unbelichteten aufgebrachten Aufzeichnungsschichten unter Wärmeeinwirkung nahtlos zu verschweißen und/oder die resultierenden Schichtoberflächen zu verformen oder zu glätten. Nachteilig bei den bekannten Verfahrensweisen ist, daß die an sich bekannte und übliche rückseitige Vorbelichtung der photoempfindlichen Aufzeichnungsschicht, wie sie z.B. in den US-A 3 210 187, 3 259 499 oder 34 08 191 beschrieben ist, nicht möglich ist.

Die übliche rückseitige vollfächige Vorbelichtung führt bei negativ arbeitendem Material bekanntlich zu einer Photovernetzung des unteren Bereichs der Aufzeichnungsschicht, bevor durch eine vorderseitige bildmäßige Hauptbelichtung eine bildmäßige Vernetzung in den belichteten Teilbereichen der unvernetzten Restschicht erfolgt, die nach Entwickeln, z.B. Auswaschen der unbelichteten Anteile der bildmäßig belichteten Restschicht die zum Druck bestimmte Reliefstruktur entstehen läßt. Die rückseitige Vorbelichtung erlaubt, auch aufgrund der dünneren unbelichteten, aber für die Reliefstruktur hinreichenden Schichtstärke der verbleibenden unvernetzten Aufzeichnungsschicht, die bildmäßige Hauptbelichtungszeit signifikant zu verkürzen und bei befriedigenden Zwischentiefen der Reliefstruktur eine gute Versockelung auch feiner Reliefelemente des entwickelten Druckreliefs zu erzielen. Wird nicht rückseitig vorbelichtet, so müssen zur ausreichenden Versockelung feiner Reliefelemente längere Zeiten für die bildmäßige Hauptbelichtung angewendet werden, was leicht zu einem Zugehen der Zwischentiefen bei feinen negativen Bildelementen führt. Führt man bei auf einen Druckzylinder aufzubringenden photovernetzbaren Aufzeichnungsschichten aber vor dem Aufbringen eine rückseitige vollflächige Vorbelichtung aus, so führt dies zu Schwierigkeiten. An den Stoßkanten der rückseitig vollflächig vorbelichteten Aufzeichnungsschicht läßt sich das Schichtmaterial nicht mehr zufriedenstellend verschweißen, wie es zur Herstellung endloser Druckzylinder zweckmäßig ist, da bekanntlich nur eine unvernetzte, nicht aber eine belichtete, vernetzte Polymerschicht sich einwandfrei verschweißen läßt. Ferner zeigt eine vernetzte Polymerschicht auf dem kontaktierten Druckzylinder bzw. der -zylinderhülse eine deutlich schlechtere Haftung. Aufgrund der nicht-möglichen Rückseitenvorbelichtung beim mit der Aufzeichnungsschicht versehenen Druckzylinder oder bei der Aufzeichnungsschicht vor dem Aufbringen auf den Zylinder lassen sich mit den Druckformen auf Druckzylindern daher meist nicht die gleichen niedrigen Tonwerte beim Druck erzielen wie mit entsprechenden ebenen photovernetzbaren Druckplatten, die eine Rückseitenvorbelichtung zulassen.

Es wurde nun gefunden, daß man diese Nachteile vermeiden kann, wenn man photoempfindliche Aufzeichnungsschichten auf die Druckzylinder oder Druckzylinderhülsen aufbringt, die zuvor rückseitig rasterartig vorbelichtet wurden, so daß in der rückseitigen bzw. unteren Schichtebene nur diskrete Volumenelemente bzw. Anteile durch die Vorbelichtung photovernetzt bzw. photopolymerisiert wurden und dazwischen in der rückseitigen Schichtebene noch unvernetztes bzw. polymerisierbares Schichtmaterial verbleibt, das die Schicht trotz der eingelagerten vernetzten Anteile noch thermoplastisch verformbar, insbesondere hinreichend verschweißbar macht.

Gegenstand der Erfindung ist somit ein Verfahren zum Beschichten von Druckzylindern oder Druckzylinderhülsen durch Aufbringen einer vorgefertigten, festen, photovernetzbaren Aufzeichnungsschicht, die zur Erzielung einer Verkürzung der erforderlichen Zeit der bildmäßigen Hauptbelichtung und einer besseren Reliefversockelung der aufgebrachten Aufzeichnungsschicht rückseitig, d.h. dessen dem Druckzylinder bzw. der Druckzylinderhülse zugewandte Schichtseite zuvor vorbelichtet wurde, auf den gegebenenfalls vorbeschichteten Druckzylinder bzw. die Druckzylinderhülse unter gleichzeitiger oder nachträglicher Einwirkung von Wärme und/oder Druck, bei dem die photovernetzbare Aufzeichnungsschicht vor dem Aufbringen rückseitig durch eine rasterartige Vorlage so vorbelichtet wird, daß die Schicht beim Aufbringen noch thermoplastisch verformbar, insbesondere noch verschweißbar ist.

Gegenstand der Erfindung sind weiterhin so hergestellte beschichtete Druckzylinder und daraus durch bildmäßiges Belichten und anschließendes Entwickeln hergestellte Druckformen, die für den Rotationsdruck besonders geeignet sind.

Das erfindungsgemäße Verfahren ist besonders geeignet zur Herstellung endlos beschichteter Druckzylinder, da es eine Verschweißen der Stoßkanten der aufgebrachten photovernetzbaren Aufzeichnungsschichten ebenso erlaubt wie deren thermoplastisches Verformen oder ein Glätten ihrer Oberflächen.

Mit den aus den Verfahrensprodukten in an sich bekannter Weise hergestellten Photopolymerdruckformen lassen sich im Rotationsdruck hochqualitative Drucke auch niedriger Tonwerte in hohen Auflagen herstellen. Zudem weisen die erfindungsgemäßen Verfahrensprodukte trotz der rückseitigen Vorbelichtung eine gute Haftung der Druckplatten, insbesondere von Flexodruckplatten auf der Zylinderoberfläche, insbesondere auch metallischen Zylinderoberflächen auf, was sich wie folgt anschaulich machen läßt. Wird die Rückseitenbelichtung z.B. mit einer Punktlichtquelle und einem Raster eines 10%igen Tonwerts durchgeführt, so entsteht in der so belichteten Schichtebene eine Art "Nagelbrett" in der thermoplastisch verformbaren Schicht. An den belichteten und so vernetzten Stellen ("Nägel") ist die Haftung schlecht, an den dazwischen liegenden unbelichteten und unvernetzten Stellen haftet die Schicht gut bis sehr gut. So haftet die Schicht als Ganzes nach dem Aufbringen und der Einwirkung von Wärme und/oder Druck noch fest auf dem Druckzylinder bzw. der Druckzylinderhülse und ergibt eine gute Schichtverankerung auch auf aufgerauhten Zylinderoberflächen.

Für den Einsatz im erfindungsgemäßen Verfahren sind als vorgefertigte feste photovernetzbare Schichten alle Schichten aus Materialien geeignet, die vor der Belichtung und Vorbelichtung thermoplastisch verformbar und unter kontrolliertem Einfluß von Wärme und/oder Druck miteinander verbunden werden können, ohne daß dadurch ihre Vernetzbarkeit durch Bestrahlung beeinträchtigt wird. Hierzu gehören insbesondere die festen, polymeren, lichtempfindlichen Schichten, die bei Erwärmung erweichen und unter Druck verfließen bzw. verkleben, wie sie für die Herstellung von Druck- und Reliefformen an sich bekannt sind. Vor allem sind hier die positiv oder negativ arbeitenden, lichtempfindlichen, photopolymerisierbaren Schichten zu nennen. Geeignete photopolymerisierbare Schichten enthalten im allgemeinen mindestens ein polymeres Bindemittel, wie z.B. lösliche Polyamide, teilverseifte Polyvinylacetate, modifizierte Polyvinylalkohole, Polyurethane, Dienpolymerisate, wie z.B. Blockcopolymerisate aus Styrol, Butadien und/oder Isopren oder Butadien/Acrylnitril-Copolymerisate, mindestens eine niedermolekulare, ethylenisch ungesättigte, photopolymerisierbare Verbindung, wie z.B. die bekannten (Meth)acrylat- oder (Meth)acrylamido-Gruppen enthaltenden Monomeren, mindestens einen Photopolymerisationsinitiator wie z.B. Benzoinether, Benzilmonoketale oder Acylphosphinoxide sowie übliche Zusatz- und/oder Hilfsstoffe, wie z.B. thermische Polymerisationsinhibitoren, Farbstoffe, Pigmente, Füllstoffe, Weichmacher, Verlaufshilfsmittel, sensitometrische Regler etc.. Insbesondere kommen für das erfindungsgemäße Verfahren die lichtempfindlichen photopolymerisierbaren Schichten in Betracht, wie sie für die Herstellung von Flexodruckformen oder Tiefdruckformen bekannt und beschrieben sind (vgl. z.B. DE-A 22 15 090, DE-A-29 02 412, EP-B-27 612, DE-A-20 61 287, EP-A-70 510, EP-A-70 511). Die Dicke der einzusetzenden lichtempfindlichen Schichten ist bei dem erfindungsgemäßen Verfahren unkritisch und kann, wie erwähnt, in weiten Grenzen variiert werden. Üblicherweise liegt die Schichtdicke im Bereich von etwa 500 μm bis etwa 7 mm.

Bevorzugt werden trägerfreie photovernetzbare Aufzeichnungsschichten für das Aufbringen verwendet, die zuvor maßgerecht und passend für den jeweiligen Zylinderumfang zugeschnitten wurden, wobei Schnittkanten ohne Unebenheiten und frei von Verunreinigungen von Vorteil sind. In manchen Fällen können die photovernetzbaren Aufzeichnungsschichten im unteren Schichtbereich, der für die spätere Ausbildung der Reliefstruktur durch bildmäßige Belichtung und anschließende Entwicklung nicht benötigt wird, jedoch auch eine gewebe- oder vliesartige, bevorzugt transparente Einlage als Verstärkung enthalten.

Als Druckzylinder oder Druckzylinderhülsen kommen vor allem Zylinder, zylindrische Hülsen, auch konisch ausgebildete Hülsen in Betracht, wie sie bekanntermaßen zum Beschichten zur Herstellung von zylindrischen Druckplatten und Druckformen für den Rotationsdruck verwendet werden, wobei diese mit Vorteil aufgerauht, aber auch beschichtet sein können. Die Oberfläche der Druckzylinder oder Druckzylinderhülsen besteht insbesondere aus Metall, Kunststoff- oder Kautschuk, worauf aber auch z.B. haftvermittelnde Schichten aufgebracht sein können.

Das Aufbringen der Aufzeichnungsschicht auf den gegebenenfalls beschichteten Druckzylinder bzw. die Druckzylinderhülsen kann in bekannter Weise erfolgen unter gleichzeitiger oder nachträglicher Einwirkung eines Vakuums zwischen Zylinder und Aufzeichnungsschicht bzw. einer sie abdeckenden Kunststoffolie oder Schrumpffolie. Hier sei auf den vorstehend zitierten Stand der Technik verwiesen. Dies gilt auch für die Herstellung endlos beschichteter Druckzylinder ohne Oberflächendeformationen und von Druckformen, die einen nahtlosen Rotationsdruck ermöglichen. Eine formgebende Nachbehandlung der aufgebrachten Aufzeichnungsschichten dient in erster Linie der Erzeugung einer durchgehenden, gleichmäßigen, nahtlosen photovernetzbaren Aufzeichnungsschicht. Sie bewirkt den Ausgleich evtl. geringer Schichtdickeschwankungen und die Erzielung eines exakt zylindrischen Umfangs. Auch kann die Oberfläche in bekannter Art geglättet werden.

Es ist das besondere Kennzeichen des erfindungsgemäßen Verfahrens, für das Aufbringen auf die Druckzylinder bzw. Druckzylinderhülsen photovernetzbare Aufzeichnungsschichten der angegebenen Art zu verwenden, die vor dem Aufbringen rückseitig, d.h. von der Seite, die nachher der Druckzylinderunterlage zugewandt ist, rasterartig vorbelichtet wurden.

Wie oben angegeben, ist die rückseitige vollflächige Vorbelichtung von Druckplatten bekannt, dem Fachmann geläufig und erzielt die oben angegebenen positiven Effekte, insbesondere eine signifikante Verkürzung der erforderlichen Zeit für die bildmäßige Hauptbelichtung von der anderen Schichtseite her. Die für das erfindungsgemäße Verfahren verwendeten Aufzeichnungsschichten sind dagegen nicht rückseitig vollflächig, sondern rückseitig derart rasterartig vorbelichtet, daß die so vorbelichtete Aufzeichnungsschicht noch thermoplastisch verformbar ist, bevorzugt auch in den unteren Schichtebenen noch eine hinreichende Verschweißbarkeit zeigt, andererseits aber auch eine erkennbare Verkürzung der erforderlichen bildmäßigen Hauptbelichtungszeit bewirkt wird. Die diskrete oder rasterartige Rückseitenvorbelichtung hat die Funktion, bestimmte diskrete Molekülbereiche so zu fixieren, daß die Schichtanteile vernetzt wirken, die die vernetzten Anteile in der Schichtebene umgebenden unvernetzten und beweglichen Moleküle als "Gleitmittel" aber eine thermoplastische Verformung, insbesondere ein Verschweißen der Schicht bzw. Schichtanteile noch gerade hinreichend ermöglichen ("Kugellagereffekt").

Dies läßt sich insbesondere durch rückseitiges Vorbelichten durch Filme mit groben Rastern mit 5 bis 25 und bevorzugt 5 bis 15 Linien/cm erzielen. Sehr geeignet ist ein Rastertonwert von 5 bis 30% und insbesondere 5 bis 15%. Besonders positive Ergebnisse, d.h. großer Vorbelichtungseffekt bei noch möglicher Verschweißbarkeit der Schicht wurden mit punktförmiger Vorbelichtung durch die Vorlage erzielt, wobei aber die Punktform auch variiert, z.B. in Rautenform, kleine Quadrat- oder Rechteckform etc. abgewandelt werden kann.

Die Zeit der rückseitigen Vorbelichtung mit aktinischem Licht bestimmt neben einer bestimmten Verbreiterung der belichteten vernetzten Schichtanteile vor allem die Dicke bzw. Tiefe der Vernetzung in den vorbelichteten Schichtbereichen. Die Tiefe der Vernetzung durch rückseitige Vorbelichtung beträgt nur einen Bruchteil der Gesamtdicke der Aufzeichnungsschicht und darf nicht in die oberen Schichtebenen eindringen, die zur Ausbildung einer hinreichenden Reliefstruktur durch die bildmäßige Hauptbelichtung von der anderen Schichtseite her benötigt werden. Andererseits soll die hinreichende Vernetzungstiefe durch die rückseitige Vorbelichtung eine deutliche Verkürzung der erforderlichen bildmäßigen Hauptbelichtungszeit ermöglichen und eine befriedigende Versockelung auch feiner Reliefelemente der entwickelten Druckform bewirken. Da diese Aufgabenstellung aber dem Fachmann geläufig ist und außer von der gewünschten Tiefe des Druckreliefs stark von der chemischen Zusammensetzung der photovernetzbaren Aufzeichnungsschicht bestimmt wird, ist die erforderliche Vorbelichtungszeit zur Erzielung eines optimalen Vorbelichtungseffekts unter Erhalt der thermoplastischen Verformbarkeit insbesondere Verschweißbarkeit der Schicht unschwierig durch einige Vorversuche zu ermitteln. Sie ist im allgemeinen kürzer als die erforderliche Hauptbelichtungszeit.

Die Erfindung wird durch das nachstehende Beispiel erläutert.

Beispiel

Auf einen dünnwandigen Druckzylinder mit Nickel-Oberfläche von einer Länge von ca. 110 cm und einem Durchmesser von ca. 120 mm wurde eine entsprechend der Zylindergröße exakt zugeschnittene trägerlose photovernetzbare Elastomerdruckplatte in bekannter Weise aufgebracht, die als Bindemittel ein A-B-C-Blockcopolymerisat mit einem Polystyrol-, einem Polyisopren- und einem Styrol-Isopren-Copolymerisat-Block, als Monomere Di-(meth)acrylate, Benzildimethylketal als Photoinitiator, einen schwarzen Farbstoff sowie ein handelsübliches Methylstyrol-Vinyltoluol-Copolymerisat enthielt. Die 3 mm starke Elastomerdruckplatte war vor dem Aufbringen durch einen Rasterfilm mit einem Raster von 5 Linien/cm und einem 10%igen Tonwert in einem Röhrenflachbelichter rückseitig vorbelichtet worden. Die Kanten der aufgebrachten Flexo-Aufzeichnungsschicht wurden bei ca. 130°C einwandfrei verschweißt und die Schichtoberfläche geglättet. Die Haftung der aufgebrachten Aufzeichnungsschicht auf dem Nickel-Druckzylinder war sehr gut.

Der Druckzylinder mit der aufgebrachten, rückseitig vorbelichteten Elastomerdruckplatte wurde dann in einem Rundbelichter vorderseitig bildmäßig belichtet, und die unbelichteten Schichtanteile wurden ausgewaschen. Das resultierende Druckrelief mit ca. 1 mm Tiefe erlaubte einen Druck einwandfreier Tonwerte von 1 bis 2%, wie dies mit gleichen, ebenen Flexodruckplatten nach vollflächiger Rückseitenbeschichtung erzielbar ist.

**Ansprüche**

1. Verfahren zum Beschichten von Druckzylindern oder Druckzylinderhülsen durch Aufbringen einer vorgefertigten, festen, photovernetzbaren Aufzeichnungsschicht, die zur Erzielung einer Verkürzung der erforderlichen Zeit der bildmäßigen Hauptbelichtung und einer besseren Reliefversockelung der aufgebrachten Aufzeichnungsschicht rückseitig, d.h. dessen dem Druckzylinder bzw. der Druckzylinderhülse zugewandte Schichtseite zuvor vorbelichtet wurde, auf den gegebenenfalls vorbeschichteten Druckzylinder bzw. die Druckzylinderhülse unter gleichzeitiger oder nachträglicher Einwirkung von Wärme und/oder Druck, dadurch gekennzeichnet, daß die photovernetzbare Aufzeichnungsschicht vor dem Aufbringen rückseitig durch eine rasterartige Vorlage so vorbelichtet wird, daß die Schicht beim Aufbringen noch thermoplastisch verformbar ist.

2. Verfahren nach Anspruch 1, dadurch kennzeichnet, daß die rückseitig vorbelichtete Aufzeichnungsschicht noch verschweißbar ist.

3. Verfahren nach Anspruch 1 oder 2, dadurch gekennzeichnet, daß die rückseitig vorbelichtete Aufzeichnungsschicht in der rückseitigen Schichtebene von photovernetzbarem Aufzeichnungsschichtmaterial begrenzte diskrete photovernetzte Schichtanteile aufweist.

4. Verfahren nach einem der Ansprüche 1 bis 3, dadurch gekennzeichnet, daß die Aufzeichnungsschicht durch eine Rastervorlage mit 5 bis 25 Linien/cm rückseitig vorbelichtet wurde.

5. Verfahren nach einem der Ansprüche 1 bis 4, dadurch gekennzeichnet, daß die Aufzeichnungsschicht durch einen Rasterfilm mit einem 5 bis 30%igen Tonwert rückseitig vorbelichtet wurde.

6. Verfahren nach einem der Ansprüche 1 bis 5, dadurch gekennzeichnet, daß die photovernetzbare Aufzeichnungsschicht eine Flexodruckplatte ist.

7. Verfahren nach einem der Ansprüche 1 bis 6, dadurch gekennzeichnet. daß ein endlos beschichteter Druckzylinder unter Verschweißen der Stoßkanten der aufgebrachten Aufzeichnungsschicht und evtl. formgebende Nachbehandlung der Aufzeichnungsschicht hergestellt wird.

8. Mit einer photovernetzbaren Aufzeichnungsschicht beschichtete Druckzylinder bzw. Druckzylinderhülsen, die gemäß einem der Verfahren der Ansprüche 1 bis 7 hergestellt sind.

## Claims

1. A process for coating printing cylinders or sleeves by mounting a preprepared, solid, photocrosslinkable recording layer which, in order to reduce the time required for principal imagewise exposure and to improve anchoring of the relief of the mounted recording layer, has been pre-exposed beforehand from the back, ie. through that side of the layer which faces the printing cylinder or sleeve, on the uncoated or precoated printing cylinder or sleeve, with simultaneous or subsequent exposure to heat or pressure, wherein the photocrosslinkable recording layer is pre-exposed from the back before mounting through a halftone transparency so that the layer is still thermoplastic on mounting.

2. A process as claimed in claim 1, wherein the recording layer which has been pre-exposed from the back is still weldable.

3. A process as claimed in claim 1 or 2, wherein the recording layer which has been pre-exposed from the back possesses, in the rear of the layer, discrete photocrosslinked parts of the layer which are bordered by photocrosslinkable material of the recording layer.

4. A process as claimed in any of claims 1 to 3, wherein the recording layer has been pre-exposed from the back through a halftone transparency having from 5 to 25 lines/cm.

5. A process as claimed in any of claims 1 to 4, wherein the recording layer has been pre-exposed from the back through a halftone film having a tonal value of from 5 to 30%.

6. A process as claimed in any of claims 1 to 5, wherein the photocrosslinkable recording layer is a flexographic printing plate.

7. A process as claimed in any of claims 1 to 6, wherein a continuously coated printing cylinder is produced by welding the abutting edges of the mounted recording layer and, if necessary, subjecting the recording layer to an aftertreatment to impart shape.

8. A printing cylinder or sleeve which is coated with a photocrosslinkable recording layer and produced by one of the processes of claims 1 to 7.

## Revendications

1. Procédé d'enduction de cylindres d'impression ou manchons de cylindres d'impression par application, sur le cylindre ou manchon de cylindre d'impression éventuellement pré-enduit, avec action simultanée ou postérieure de chaleur et/ou de pression, d'une couche d'enregistrement photoréticulable, solide, préfabriquée, qui, pour obtenir un raccourcissement du temps nécessaire à l'exposition principale, selon une image, et une meilleure mise en place du relief de la couche d'enregistrement appliquée, a été d'abord pré-exposée sur la face arrière, c'est-à-dire la face de la couche tournée vers le cylindre ou manchon de cylindre d'impression, caractérisé par le fait que la couche d'enregistrement photoréticulable est, avant l'application, pré-exposée sur la face arrière à travers un ,document tramé de telle sorte que la couche est encore thermoplastiquement déformable lors de l'application.

2. Procédé selon la revendication 1, caractérisé par le fait que la couche d'enregistrement pré-exposée sur la face arrière est encore soudable.

3. Procédé selon la revendication 1 ou 2, caractérisé par le fait que la couche d'enregistrement pré-exposée sur la face arrière présente, dans le plan de couche arrière, des portions de couche photoréticulées, discrètes, limitées par du matériau d'enregistrement photoréticulable.

4. Procédé selon l'une des revendications 1 à 3, caractérisé par le fait que la couche d'enregistrement est pré-exposée sur la face arrière à travers un document tramé de 5 à 25 lignes/cm.

5. Procédé selon l'une des revendications 1 à 4, caractérisé par le fait que la couche d'enregistrement est pré-exposée sur la face arrière à travers un film tramé d'une tonalité de 5 à 30 %.

6. Procédé selon l'une des revendications 1 à 5, caractérisé par le fait que la couche d'enregistrement photoréticulable est une plaque de flexographie.

7. Procédé selon l'une des revendications 1 à 6, caractérisé par le fait qu'on fabrique un cylindre d'impression enduit, sans fin, avec soudure des bords de la couche d'enregistrement appliquée et post-traitement de formage éventuel de la couche d'enregistrement.

8. Cylindre ou manchon de cylindre d'impression enduit d'une couche d'enregistrement photoréticulable qui a été fabriqué selon un des procédés des revendications 1 à 7.